Europäisches Patentamt

European Patent Office

Office européen des brevets

(11) Publication number: **0 485 623 A1**

# EUROPEAN PATENT APPLICATION
## published in accordance with Art. 158(3) EPC

(21) Application number: **91909799.8**

(22) Date of filing: **22.05.91**

(86) International application number:
**PCT/JP91/00683**

(87) International publication number:
**WO 91/19318 (12.12.91 91/28)**

(51) Int. Cl.5: **H01L 21/66**, G01R 31/26

(30) Priority: **05.06.90 JP 146751/90**
**05.06.90 JP 146752/90**

(43) Date of publication of application:
**20.05.92 Bulletin 92/21**

(84) Designated Contracting States:
**DE FR GB NL**

(71) Applicant: **SEIKO EPSON CORPORATION**
**4-1, Nishishinjuku 2-chome**
**Shinjuku-ku Tokyo 163(JP)**

(72) Inventor: **TAKEI, Hideki**
**3-5, Owa 3-chome**
**Suwa-shi, Nagano-ke 392(JP)**

(74) Representative: **Blumbach Weser Bergen**
**Kramer Zwirner Hoffmann Patentanwälte**
**Radeckestrasse 43**
**W-8000 München 60(DE)**

(54) **SEMICONDUCTOR DEVICE PROVIDED WITH LOGICAL CIRCUIT FOR MEASURING DELAY.**

(57) A logical circuit (26) for measuring the delay of a semiconductor device is formed substantially in not a logical circuit region (14) but its peripheral region (12). A plurality of inverter gates ($26_1$-$26_n$) configuring the logical circuit (26) and wirings between those gates ($GL_1$-$GL_n$) are incorporated in the region (12) and along two boundaries (27a, 27b) of the four boundaries between the peripheral region (12) and the logical region (14), the boundaries (27a, 27b) corresponding to two sides (10a, 10b) of a chip (10) respectively. Thereby, the variation of the delay time of the logical circuit can be suppressed and the highly reliable estimation of the operating speed relative to the logical circuit block of a semiconductor device is possible.

FIG. 1

Rank Xerox (UK) Business Services
(3.08/2.19/2.0)

## Technical Field

The present invention relates to a semiconductor device such as an ASIC, and, more particularly, to a semiconductor device having a logical circuit block which is a main component for performing a predetermined logical operation and an auxiliary delay-measuring logical circuit the operational speed of which must be indirectly evaluated.

## Background Art

With the recent trend of high-density integration of semiconductor integrated circuits and high speed operation of the same, it is difficult to perform the delivery inspection of the semiconductor integrated circuit under the same conditions as those when it is used because of the limit present in the inspection device and the inspecting conditions and the like. In an evaluation test about a semiconductor integrated circuit, whether or not the operation can be performed as desired must be inspected and the operational speed must be measured. As an alternative to an actual operation test, the operation inspection is performed in such a manner that a low speed input signal is supplied to a prepared predetermined logical circuit to confirm the operation. The operational speed is evaluated in such a manner that the quantity of delay of a delay measuring logical circuit, which has been simultaneously formed in the integrated circuit, is measured so as to indirectly estimate the operational speed.

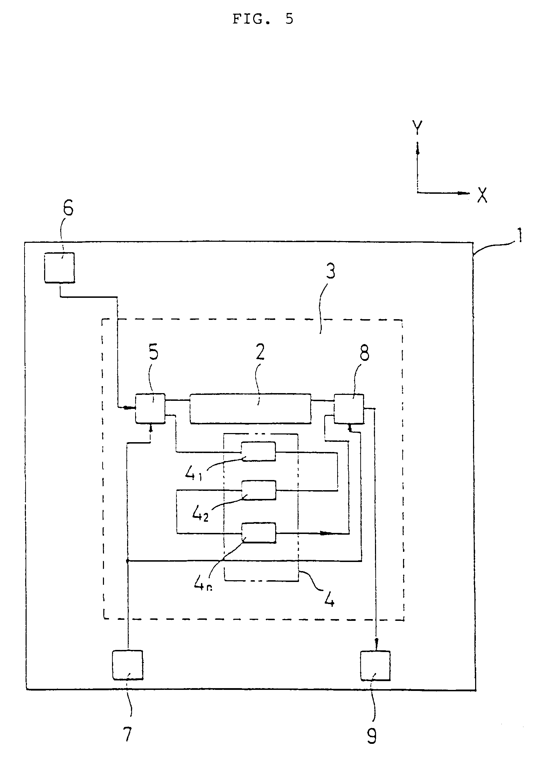

Hitherto, a semiconductor device having a delay measuring logical circuit of the above-described type is, as shown in Fig. 5, structured in such a manner that a logical circuit region 3, which is formed at the central portion of a semiconductor chip 1 and which includes a predetermined logical circuit block 2, includes a delay measuring logical circuit 4. The delay measuring logical circuit 4 is connected to the logical circuit block 2 in parallel. For example, it is a series circuit composed of a plurality of inverters $4_1$ and $4_2$ to $4_n$ connected to form a multistage. Reference numeral 5 represents an input-side switch circuit for supplying an input signal supplied through a common input terminal 6 to the logical circuit block 2 or the delay measuring logical circuit 4 selected in accordance with a circuit selection signal supplied through a selection control terminal 7. Reference numeral 8 represents an output-side switch circuit for supplying an output signal from the logical circuit block 2 or an output signal from the delay measuring logical circuit 4 selected in accordance with the circuit selection signal to a common output terminal 9. In order to indirectly evaluate the operational speed of the logical circuit block 2 by obtaining the quantity of delay from the waveform output from the delay measuring logical circuit 4, the delay measuring logical circuit 4 is formed in a region adjacent to the region in which the logical circuit block 2 is formed. The reason for this lies in that, in order to further accurately reflect the quantity of delay of the logical circuit block 2, the delay measuring logical circuit 4 must be, in the process of manufacturing the semiconductor, formed in a region which approximates the region having the same scatter in the performance of the device and the same scatter in the width of the electric line and the like.

However, the delay measuring logical circuit 4 performs only a criterion-like role to indirectly evaluate the quantity of delay of the logical circuit block 2. Furthermore, if the delay measuring logical circuit 4 is formed in the logical circuit region 3, the physical structure of the gate, the number of gates, the length of the electric line and the number of the contacts are basically different from those of the logical circuit block 2. For example, the route in which the electric line is arranged in the delay measuring logical circuit 4 is considerably different from that provided in the logical circuit block 2.

The delay time of the logical circuit block 2 is determined in accordance with (1) the basic delay in the gate, (2) the length of the electric line and (3) the number of fanouts. In general, the delay time of the portion determined depending upon the number of fanouts can be evaluated by using an imaginary delay means. The basic delay in the gate can be evaluated in such a manner that the performance (the length of the channel, the width of the channel and the like) of the gate which constitutes the delay measuring logical circuit 4 is set to the same or similar (proportional) to those of the gate which constitutes the logical circuit block 2. However, it is impossible to establish a correlation about the route of the electric line and the length of the same between the logical circuit block 2 and the delay measuring logical circuit 4. The reason for this lies in that the delay measuring logical circuit involves scatter in the delay time between chips. Since the delay measuring logical circuit 4, which is irrelevant to the predetermined logical block 2 formed in the logical circuit region 1, must be dispersively formed in the residual region in the logical circuit region 3, the line route relating to the delay measuring logical circuit 4 does not usually substantially correlate to that of the logical circuit block 2. Furthermore, it is impossible to design the circuit layout of the delay measuring logical circuit 4 in such a manner that the above-described correlation is established because of the limit present in the design freedom and the necessity of reducing the design cost.

Accordingly, the present invention is able to overcome the above-described problems and an object of the same therefore is to provide a semiconductor device having a delay measuring logical circuit and employing a chip layout capable of preventing scatter in the delay time of the delay measuring logical circuit, whereby the operational speed of the logical circuit block can be reliably evaluated.

Disclosure of the Invention

As a general rule, a semiconductor integrated circuit such as an ASIC is arranged in such a manner that the region in which the device is formed is divided into a logical region and a peripheral region. The logical region is mainly formed at the central portion of the semiconductor chip, the logical region being a region which includes a logical circuit block for performing a predetermined logical operation. The peripheral region is a region which is formed around the logical region and which includes an I/O portion for treating an I/O signal supplied/received between an external portion of the semiconductor chip and the logical circuit block. In the semiconductor device thus-constituted, a means employed according to the present invention is arranged in such a manner that a layout is employed in which a delay measuring logical circuit for selectively fetching an input signal supplied to the logical circuit block or fetching a sole signal to make an input is not formed in the logical region but is formed in the peripheral region. Furthermore, a substantially major portion of a plurality of gates which constitute the above-described delay measuring logical circuit and the electric lines between their gates are formed along the boundaries between the peripheral region and the logical region. The term "gate" according to this description means an inverter gate, a buffer gate, a NAND gate and a combined gate of them including the same or different gates. It is preferable that the formed size (for example, the length of the gate, the width of the gate and the direction of the gate of the MOS and the like) of a transistor which constitutes each of the gates be the same as that of a transistor which constitutes the logical circuit block. A further specific structural example of the present invention employs a type of a structure arranged in such a manner that each of the gates which constitute the delay measuring logical circuit is formed in each of the cells of the I/O portion. In this case, the electric line between gates is arranged to intersect an I/O line which establishes a connection between an I/O logical circuit such as a buffer circuit for the above-described cell and the logical circuit block. The above-described lines between the gates may be made to be a line disposed below the I/O line. Although a plurality of the gates which constitute the above-described delay measuring logical circuit may be formed along only the first boundary which corresponds to the first side of the semiconductor chip, it may be further formed along the second boundary which corresponds to the second side which substantially intersects the first side. A simple delay-measuring logical circuit is a series circuit composed of the inverter gates connected to form a multistage.

According to the present invention, since an auxiliary delay measuring logical circuit is formed in the peripheral region, undesirable expansion of the area of the logical circuit region can be prevented even if the scale of the logic is enlarged. Furthermore since the gates constituting the delay measuring logical circuit are formed along the boundary region, the pitch between gates and the like can be made to be regular so as to correspond to the arrangement of the I/O cells. According to the above-described arrangement, an advantage can be realized in comparison to a structure in which the delay measuring logical circuit is dispersively formed in the logical region, the advantage being an advantage obtained in that the route of the electric line of the delay measuring logical circuit can be uniformly arranged. Another advantage can be obtained in that the number of gates, which constitute the delay measuring logical circuit, can be secured to enable the shortest delay time required to measure the delay time. Therefore, scatter in the delay time of the delay measuring logical circuit can be prevented. As a result, the result of the measurement or the delay time obtainable from the delay measuring logical circuit is an advantageous index for evaluating the quantity of delay. As a result, a reliable value can be obtained as the evaluated operational speed of the logical circuit block. The design of the layout of the delay measuring logical circuit can, of course, be easily performed.

As described above, since the semiconductor device having the delay measuring logical circuit according to the present invention is characterized in that its delay measuring logical circuit is, in the peripheral region, which is the I/O portion of the semiconductor chip, formed along the boundary from the logical circuit region, the following effects can be obtained:

(1) Since the portion in which the delay measuring logical circuit is formed is not included in the logical region, the enlargement of the area of the logical circuit region, which is formed in the major portion, can be prevented. That is, the size of the chip can be reduced.

(2) Since the gates constituting the delay measuring logical circuit are formed along the boundary region, the pitch between the gates and the route of the lines can be regularly and uniformly arranged to correspond to the arrangement of the I/O cells. Therefore, scatter in the delay time can be prevented so that the operational speed of the logical circuit block can be stably and reliably evaluated. Furthermore, the design of the layout of the delay measuring logical circuit can be significantly simplified in comparison to the conventional structure.

(3) Since a larger number of the gates for the delay measuring logical circuit can be secured in comparison to the conventional structure, setting of the required delay time can be afforded. Therefore, a longer absolute delay time can be set, causing the degree of scatter in the delay time to be compressed.

Brief Description of Drawings

Fig. 1 is a schematic chip layout drawing of a semiconductor chip according to Example 1 of the present invention;
Fig. 2 is a partial view which illustrates the arrangement of inverter gates which constitute a delay measuring logical circuit according to Example 1;
Fig. 3 is a schematic chip layout drawing of a semiconductor chip according to Example 2 of the present invention;
Fig. 4 is a schematic chip layout drawing of a semiconductor chip according to Example 3 of the present invention; and
Fig. 5 is a schematic chip layout drawing of a semiconductor device having a conventional delay measuring logical circuit.

Best Mode for Carrying Out the Invention

Then, embodiments of the present invention will now be described with reference to the drawings.

(Embodiment 1)

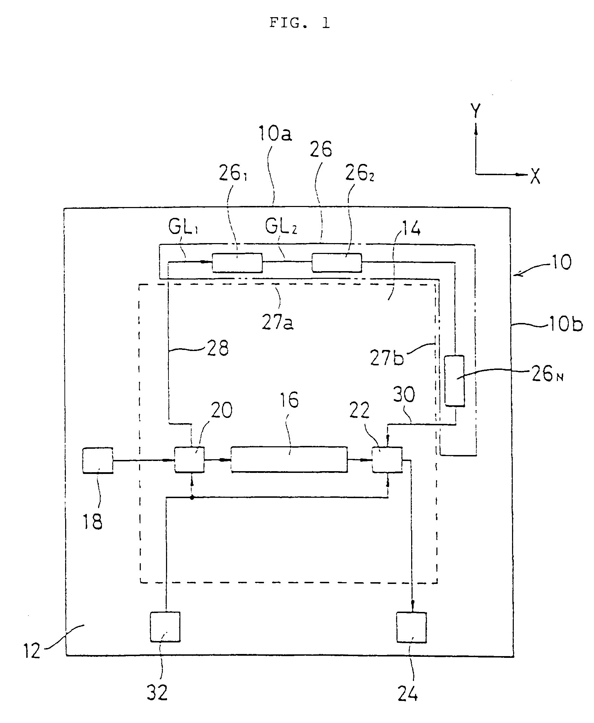

Fig. 1 is a schematic layout drawing which illustrates Embodiment 1 of the present invention.

The layout of a chip of a semiconductor device according to this embodiment comprises a peripheral region 12 of a rectangular chip 10 and a logical region 14 formed inside of the peripheral region 12. In the logical region 14, there is formed a logical circuit block 16 which is the nucleus for performing a predetermined logical operation. Referring to Fig. 1, only one logical circuit block is shown. An input signal to be received by the logical circuit block 16 is supplied through a common input terminal (an input pad) 18 and an input-side switch circuit 20 which is a multiplexer formed in the logical region 14. An output signal transmitted from the logical circuit block 16 is fetched through an output-side switch circuit 22 which is a multiplexer formed in the logical region 14 and a common output terminal (output pad) 24 formed in the peripheral region 12. A delay measuring logical circuit 26 is substantially formed in the peripheral region 12. That is, it is formed along a portion of the boundary between the peripheral region 12 and the logical region 14, that is, along a boundary 27a which corresponds to a side 10a of the chip 10 and a boundary 27b which corresponds to a side 10b. The above-described delay measuring logical circuit 26 is a multi-stage series connected circuit comprising CMOS inverter gates $26_1$ to $26_N$. The size of the MOS transistor which constitutes the above-described gates is the same as that of a MOS transistor which constitutes the logical circuit block 16. The circuit 26 may be constituted by buffer gates or NAND gates in place of the inverter gates.

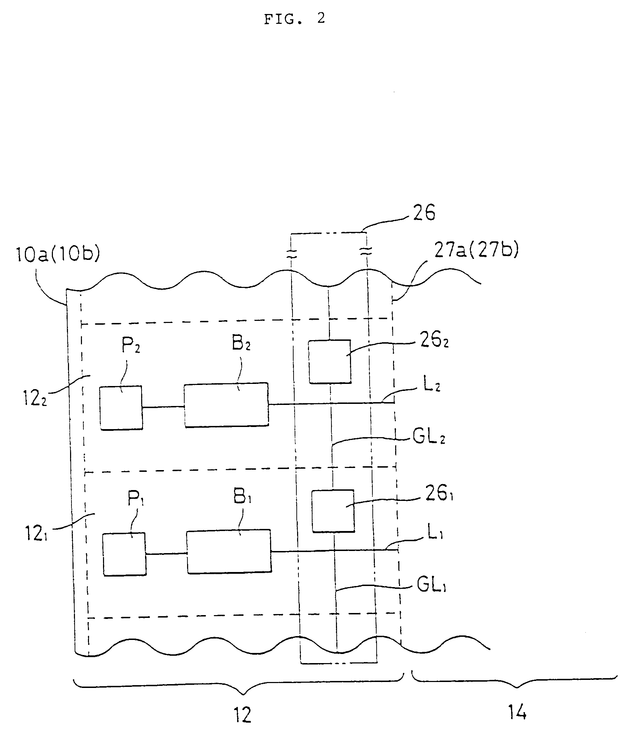

In the peripheral region 12, I/O cells $12_1$ to $12_n$ are disposed as shown in Fig. 2. Each of the cells has an input or output terminal (a pad) P and an I/O logical circuit B connected to it. The I/O logical circuit B and the logical circuit block 16 disposed in the logical region 14 are connected to each other via I/O lines $L_1$ to $L_n$. The I/O lines $L_1$ to $L_n$ are aluminum lines which are the second layer. Between I/O logical circuits $B_1$ to $B_n$ of the I/O cell and a boundary 27a (27b), the inverter gates $26_1$ to $26_n$ which constitute the delay measuring logical circuit 26 are formed. In the region in each of the cells, the inverter gates of the delay measuring logical circuit 26 are included. A portion of the cells $12_1$ to $12_n$ may include a cell which does not contain the inverter gate. The necessity of forming an individual inverter gate for each of the cells can be eliminated. A line GL electrically connecting the adjacent inverter gates to each other intersects an I/O line L. The line GL arranged between the gates is an aluminum line forming the first layer. However, the positional relationship realized by the intersection made between the I/O line L and the line GL between the gates may be reversed.

The input-side switch circuit 20 formed in the logical region 14 and the first inverter gate $26_1$ are connected to each other via an extension line 28 placed in the logical region 14. Furthermore, the final inverter gate $26_N$ and the output-side switch circuit 22 formed in the logical region 14 are connected to each other via a leading-in line 30 placed in the logical region 14. The input-side switch circuit 20 serving as the multiplexer supplies an input signal supplied through the input terminal 18 to the logical circuit block 16 or the delay measuring logical circuit 26 selected in accordance with a circuit selection signal supplied from a selection control terminal 32. The output-side switch circuit 22 serving as the multiplexer selects the signal output from the logical block 16 or the signal output from the delay measuring logical circuit 26 in accordance with the circuit selection signal to supply it to the output terminal 24. As an alternative to the input-side switch circuit 20 and the output-side switch circuit 22, an exclusive input terminal or output terminal for the delay measuring logical circuit 26 may be formed in the peripheral region 12.

According to the semiconductor device arranged as described above in such a manner that the delay measuring logical circuit 26 is formed in the peripheral region 12 along the boundaries 27a and 27b, the space required to form the logical region 14 can be reduced and the degree of freedom at the time of high density integration in the logical circuit block 16 can be improved, and also the reliability in evaluating the delay time can be improved. That is, since a plurality of the inverter gates $26_1$ to $26_N$ constituting the delay measuring logical circuit 26 are not dispersively and eccentrically disposed in the residual portions in the logical region 14 after the arrangement of the logical circuit block 16 has been completed, but are substantially regularly disposed along the boundary of the peripheral region 12, the delay time realized in the delay measuring circuit 26 can be stabled when compared between chips.

When the delay measuring logical circuit 26 is formed in the logical region 14, the lines connecting the gates undesirably meander as well as the dispersive arrangement of the inverter gates. In this case, the route of the line connecting the gates becomes substantially irrelevant to the number of the inverter gates, that of the bent portions of the line, the X-directional length, the Y-directional length and the number of contact holes. Although the delay time of the delay measuring logical circuit is measured so as to evaluate the operational speed of the logical circuit block, the delay time of the delay measuring logical circuit includes excessively large scatter when compared between chips in a case where the delay measuring logical circuit is dispersively formed in the logical region. The excessively large scatter in the delay time will disable the operational speed of the logical circuit block to be evaluated. Therefore, the object of forming the delay measuring logical circuit is undesirably eliminated, and, what is even worse, the performance in terms of the speed of the semiconductor device to be delivered cannot be guaranteed. The above-described problems become apparent with the advance of the degree of integration and minimization of the semiconductor devices. The correlation between the logical circuit block and the delay time of the delay measuring circuit can be relatively evaluated depending upon the result of the actual measurement. Therefore, there arises a desire to prevent scatter in the delay time of the delay measuring circuit. According to the layout structure of the conventional delay measuring logical circuit, there is substantially no correlation between the bent portions of the lines, the X-directional length, the Y-directional length and the number of contact holes. Because of the additional scatter present in the process, the scatter in the delay time of the delay measuring circuit takes place. On the other hand, according to this embodiment, the simply-structured delay measuring logical circuit 26 is formed in which the X-directional length, the Y-directional length and the number of contact holes of the inverter gates $26_1$ to $26_N$ can be uniformly and regularly set. As a result, scatter in the delay time of the delay measuring logical circuit 26 can be prevented.

Since a capacity of the delay measuring logical circuit 26 depends upon the load connected to the output terminal, the delay time on the output buffer side is 10 ns or more which is a relatively larger value in comparison to the total stages of the gates. Therefore, there is, in usual, a desire of a delay time of 40 ns or longer to be realized and thereby it is preferable that the number of the gates be 200 stages or more. However, it is difficult for the conventional structure in which the delay measuring logical circuit 26 is dispersively formed in the logical region to secure a sufficiently large number of gates. However, since a multiplicity of gates can be regularly and circularly disposed along the boundary according to this embodiment, a large number of gates for the delay measuring logical circuit 26 can be disposed in comparison to the convention structure. According to this embodiment, 500 or more stages of the gates can be secured although depending upon the chip size. Therefore, the delay time on the output buffer side can be relatively shortened, causing the degree of scatter in the delay time to be compressed.

As shown in Fig. 1, although the inverter gates are formed along the boundary 27b as well as along the boundary 27a, another structure of the delay measuring logical circuit may be employed in which the inverter gates are formed along either of the two boundaries. The reason for this lies in that the number of the inverter gates disposed along a single boundary is sometimes sufficient to make an evaluation of the delay time. However, the inverter gates may be disposed along the two or more boundaries in a case where the delay measuring logical circuit 26 is intentionally arranged in consideration of the delay factor of the logical circuit block 16 in such a manner that the length between the gates (the X-directional length and the Y-directional length) and the number of the contacts are set.

In a case where a structure is arranged in such a manner that a branch line is extended from an intermediate position between the gates connected in series and the extension line is connected to an intermediate output terminal, the difference in the delay times can be measured. Therefore, only the delay time, which does not include the delay time on the output buffer side and which corresponds to the difference in the number of the gates, can be calculated.

(Second Embodiment 2)

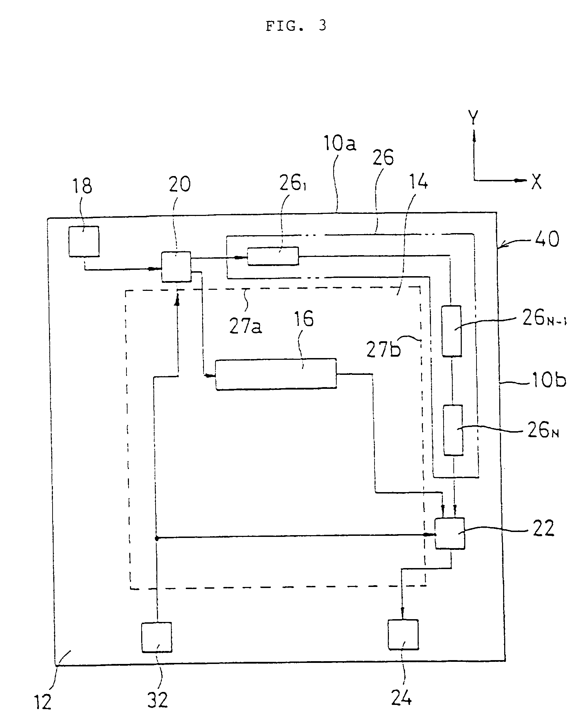

Fig. 3 is a schematic layout drawing which illustrates Embodiment 2 of the present invention. Referring to Fig. 3, the same elements as those shown in Fig. 1 are given the same reference numerals and their descriptions are omitted here.

A semiconductor device chip 40 according to this embodiment is arranged in such a manner that the input-side signal switch circuit 20 and the output-side signal switch circuit 22 are formed in the peripheral region 12. Therefore, a signal line between the input terminal 18 and the delay measuring logical circuit 26 and a signal line between the delay measuring logical circuit 26 and the output terminal 24 are also disposed in the peripheral region 12. Furthermore, the extension line 28 and the lead-in line 30 both of which are placed in the logical region 14 according to Embodiment 1 are omitted from the structure. All of the delay factors relating to the delay measuring logical circuit 26 are formed in the peripheral region 12. Also according to this embodiment, scatter in the delay time of the delay measuring logical circuit 26 can be prevented, the space required to form the logical circuit region 14 can be saved and the size of the chip can be reduced.

(Embodiment 3)

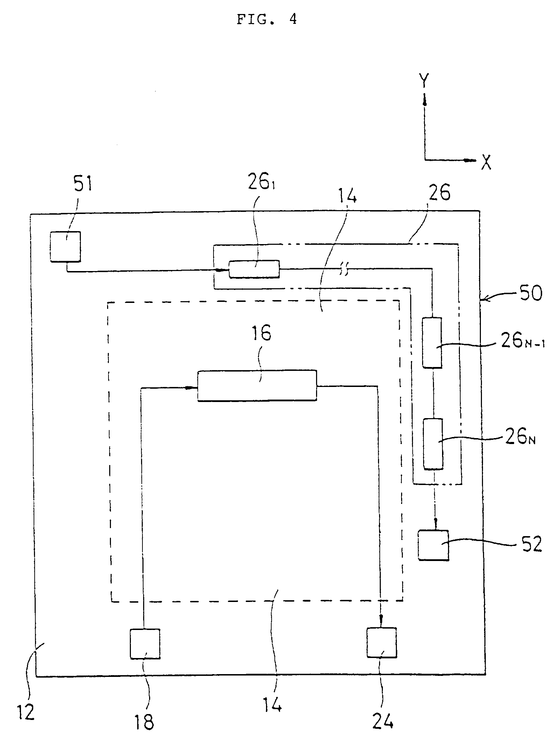

Fig. 4 is a schematic layout drawing which illustrates Embodiment 1 of the present invention. Referring to Fig. 4, the same elements as those shown in Fig. 1 are given the same reference numerals and their descriptions are omitted here.

A chip 50 according to this embodiment is arranged in such a manner that the input-side signal switch circuit 20 and the output-side signal switch circuit 22, both of which are provided for the structure according to Embodiment 1, are omitted. However, as an alternative to the common terminals, an exclusive input terminal 51 and an exclusive output terminal 52 for the delay measuring logical circuit 26 are formed in the peripheral region 12. Although the number of the pads is undesirably increased because the exclusive terminals 51 and 52 are formed, an advantage is realized in that uncertain delay factors relating to the input-side signal switch circuit 20 and the output-side signal switch circuit 22 can be eliminated.

Industrial Applicability

As described above, the semiconductor device having the delay measuring logical circuit according to the present invention is suitable when semiconductor integrated circuits exhibiting reduced scatter in the operational speed are obtained.

**Claims**

1. A semiconductor device having a delay measuring logical circuit and including a logical region which is mainly formed in the central portion of a semiconductor chip and which includes a logical circuit block for performing a predetermined logical operation and a peripheral region which is formed around said logical region and which includes an I/O portion treating an I/O signal supplied/received between an external portion of said semiconductor chip and said logical circuit block, said semiconductor device comprising: an auxiliary delay measuring logical circuit for selectively fetching a signal supplied to said logical circuit block or fetching a sole signal so as to make it as an input, wherein a substantially major portion of a plurality of gates which constitute said delay measuring logical circuit and lines between said gates are formed along a boundary present in said peripheral region between said peripheral region and said logical region.

2. A semiconductor device having a delay measuring logical circuit according to Claim 1, wherein the size of a transistor which constitutes each of said gates is the same as that of said logical circuit block.

3. A semiconductor device having a delay measuring logical circuit according to Claim 1 or 2, wherein a direction in which said transistor, which constitutes each of said gates, is formed is the same as that in which said logical circuit block is formed.

4. A semiconductor device according to any one of Claims 1 to 3, wherein each of said gates which constitute said delay measuring logical circuit is formed in each of cells in said I/O portion in such a manner that said gate corresponds to said cell.

5.  A semiconductor device having a delay measuring logical circuit according to Claim 4, wherein said line between said gates is arranged to intersect an I/O line which establishes a connection between an I/O logical circuit of said cell and said logical circuit block.

6.  A semiconductor device having a delay measuring logical circuit according to any one of Claims 1 to 5, wherein a plurality of said gates which constitute said delay measuring logical circuit are formed along a first boundary which corresponds to a first side of said semiconductor chip and a second boundary which corresponds to a second side of the same which is substantially perpendicular to said first side.

7.  A semiconductor device having a delay measuring logical circuit according to any one of Claims 1 to 6, wherein said delay measuring logical circuit is a series circuit constituted by connecting inverter gates connected to form a multi-stage.

FIG. 1

FIG. 2

FIG. 3

FIG. 4

FIG. 5

# INTERNATIONAL SEARCH REPORT

International Application No PCT/JP91/00683

**I. CLASSIFICATION OF SUBJECT MATTER** (if several classification symbols apply, indicate all) 6

According to International Patent Classification (IPC) or to both National Classification and IPC

Int. Cl⁵   H01L21/66, G01R31/26

**II. FIELDS SEARCHED**

| Minimum Documentation Searched 7 | |
|---|---|
| Classification System | Classification Symbols |
| IPC | H01L21/66, G01R31/26 |

Documentation Searched other than Minimum Documentation
to the Extent that such Documents are Included in the Fields Searched 8

| | |
|---|---|
| Jitsuyo Shinan Koho | 1970 - 1991 |
| Kokai Jitsuyo Shinan Koho | 1972 - 1991 |

**III. DOCUMENTS CONSIDERED TO BE RELEVANT** 9

| Category * | Citation of Document, 11 with indication, where appropriate, of the relevant passages 12 | Relevant to Claim No. 13 |
|---|---|---|
| Y | JP, A, 63-234553 (NEC Corp.), September 29, 1988 (29. 09. 88), Figs. 1 to 2 and its explanation (Family: none) | 1-7 |
| Y | JP, A, 1-115155 (Control Data Corp.), May 8, 1989 (08. 05. 89), Fig. 2 and its explanation | 1-7 |
| Y | JP, A, 1-176963 (NEC Corp.), July 13, 1989 (13. 07. 89), Fig. 1 and its explanation (Family: none) | 1-7 |
| Y | JP, A, 62-199026 (Fujitsu Ltd.), September 2, 1987 (02. 09. 87), Fig. 2 and its explanation (Family: none) | 1-7 |
| Y | JP, A, 58-143544 (NEC Corp.), August 26, 1983 (26. 08. 83), Fig. 2 and its explanation (Family: none) | 1-7 |

\* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure. use. exhibition or other means

"P" document published prior to the international filing date but later than the priority date claimed

"T" later document published after the international filing date or priority date and not in conflict with the application but cited to understand the principle or theory underlying the invention

"X" document of particular relevance: the claimed invention cannot be considered novel or cannot be considered to involve an inventive step

"Y" document of particular relevance: the claimed invention cannot be considered to involve an inventive step when the document is combined with one or more other such documents. such combination being obvious to a person skilled in the art

"&" document member of the same patent family

**IV. CERTIFICATION**

| Date of the Actual Completion of the International Search | Date of Mailing of this International Search Report |
|---|---|
| July 8, 1991 (08. 07. 91) | August 26, 1991 (26. 08. 91) |

| International Searching Authority | Signature of Authorized Officer |
|---|---|
| Japanese Patent Office | |